# EUROPÄISCHE PATENTANMELDUNG

(11) **EP 3 502 581 A1**
(43) Veröffentlichungstag der Anmeldung: **26.06.2019**
(21) Anmeldenummer: 18215441.9
(22) Anmeldetag: 21.12.2018
(51) Int. Cl.: F24F 11/36, H05K 7/20

(54) **KLIMASCHRANK UND WÄRMERÜCKGEWINNUNGSSYSTEM**

(30) Priorität: 22.12.2017 DE 202017006578 U
(71) Anmelder: Roggenkamp, Thomas, 82152 Planegg (DE)
(72) Erfinder: ROGGENKAMP, Thomas, 82152 Planegg (DE); KUNZE, Christian, 82110 Germering (DE)
(74) Vertreter: Linsmeier, Josef

(57) **Zusammenfassung**

Die Erfindung einen Klimaschrank (1) zur Klimatisierung von Räumen oder Raumbereichen mit: einem Gehäuse (10) mit einer ersten Öffnung (2) und einer zweiten Öffnung (9), mindestens einer Strömungseinrichtung (4), die dazu eingerichtet ist, im Innern des Gehäuses (10) einen Luftstrom zwischen der ersten und zweiten Öffnung (2, 9) des Gehäuses (10) zu erzeugen, wobei Luft aus der Umgebung des Gehäuses (10) durch die erste Öffnung (2) in das Gehäuse (10) hinein und durch die zweite Öffnung (9) wieder aus dem Gehäuse (10) heraus strömt, und mindestens einer Kompressionskältemaschine oder Kompressionswärmemaschine mit einem geschlossenen Kältemittelkreislauf, der mindestens eine im Gehäuse (10) befindliche kältemittelführende Komponente (6, 8, 15, 18), insbesondere einen Verdampfer (6) bzw. Kondensator (15), aufweist, durch welche die Temperatur der durch das Gehäuse strömenden Luft beeinflussbar ist, wobei die Strömungseinrichtung (4) und/oder mindestens eine im Gehäuse (10) befindliche Zündquelle (5), durch welche eine Zündung eines gegebenenfalls im Gehäuse (10) befindlichen Kältemittel-Luft-Gemisches ausgelöst werden kann, in Bezug auf die Richtung des Luftstroms vor der mindestens einen im Gehäuse (10) befindlichen Komponente (6, 8, 15, 18) des Kältemittelkreislaufs angeordnet ist bzw. sind. Die Erfindung betrifft ferner ein Wärmerückgewinnungssystem mit einem solchen Klimaschrank (1).

## Beschreibung

Die Erfindung betrifft einen Klimaschrank zur Klimatisierung, insbesondere zum Heizen und/oder Kühlen, von Räumen, Raumbereichen oder Prozessen sowie ein Wärmerückgewinnungssystem.

Klimaschränke kommen bei diversen privaten oder gewerblichen Anwendungen zum Einsatz, unter anderem bei der Kühlung bzw. generell bei der Klimatisierung von EDV-Räumen. Über die Raumluft gelangt die von Verbrauchern abgegebene Wärmeenergie zu einem Klimaschrank und wird dort über einen geschlossenen Kältemittelkreislauf der Raumluft, welche den Klimaschrank durchströmt, entzogen und abgeführt. Die abgeführte Wärme kann wiederum an eine Temperiereinrichtung wie etwa eine Heizung abgegeben werden, um beispielsweise einen weiteren Raum zu temperieren. Die Nutzung des Kältekreislaufes kann auch zur Beheizung und Nachheizung genutzt werden, wodurch mehrere Funktionen (z.B. Kühlen, Heizen, Entfeuchten) des Klimaschrankes möglich sind.

Je nach verwendetem Kältemittel können von solchen Klimaschränken bei Austritt von Kältemittel aus dem Kältemittelkreislauf Gefahren ausgehen.

Es ist eine Aufgabe der Erfindung, einen Klimaschrank zur Klimatisierung von Räumen sowie ein Wärmerückgewinnungssystem anzugeben, bei dem, insbesondere bei flexibler Einsetzbarkeit, einfacher Inbetriebnahme und effizienter Energienutzung, etwaige Gefahren durch ggf. austretendes Kältemittel reduziert werden.

Diese Aufgabe wird durch einen Klimaschrank gemäß Anspruch 1 und ein Wärmerückgewinnungssystem gemäß Anspruch 14 gelöst.

Ein erfindungsgemäßer Klimaschrank zur Klimatisierung von Räumen, Raumbereichen oder Prozessen weist auf: ein Gehäuse mit einer ersten Öffnung und einer zweiten Öffnung, mindestens eine Strömungseinrichtung, die dazu eingerichtet ist, im Innern des Gehäuses einen Luftstrom zwischen der ersten und zweiten Öffnung des Gehäuses zu erzeugen, wobei Luft aus der Umgebung des Gehäuses durch die erste Öffnung in das Gehäuse hinein und durch die zweite Öffnung wieder aus dem Gehäuse heraus strömt, und mindestens einer Kompressionskältemaschine oder Kompressionswärmemaschine mit einem geschlossenen Kältemittelkreislauf, der mindestens eine im Gehäuse befindliche kältemittelführende Komponente, insbesondere einen Verdampfer bzw. Kondensator, aufweist, durch welche die Temperatur der durch das Gehäuse strömenden Luft beeinflussbar ist. Die Strömungseinrichtung und/oder mindestens eine im Gehäuse befindliche Zündquelle, durch welche eine Zündung eines gegebenenfalls im Gehäuse befindlichen Kältemittel-Luft-Gemisches ausgelöst werden kann, ist bzw. sind dabei erfindungsgemäß in Bezug auf die Richtung des Luftstroms vor der mindestens einen im Gehäuse befindlichen kältemittelführende Komponente des Kältemittelkreislaufs angeordnet.

Ein erfindungsgemäßes Wärmerückgewinnungssystem weist auf: mindestens einen erfindungsgemäßen Klimaschrank mit mindestens einem im Inneren des Gehäuses des Klimaschranks befindlichen Kondensator, welcher dazu eingerichtet ist, das Kältemittel unter Abgabe von Wärme an eine Kühlflüssigkeit, insbesondere Wasser, zu verflüssigen, und mindestens eine Heizungsvorrichtung, welche dazu eingerichtet ist, unter Verwendung der vom Kondensator abgeführten erwärmten Kühlflüssigkeit Brauchwasser und/oder eine Flüssigkeit, insbesondere Wasser, zur Verwendung bei einer Gebäudeheizung zu erwärmen.

Ein Aspekt der Erfindung basiert auf dem Ansatz, Einrichtungen des Klimaschranks, welche eine Funkenbildung, Erhitzung bzw. Zündung von aus dem Kältemittelkreislauf eventuell austretendem Kältemittel hervorrufen können, in einem ersten Bereich des Klimaschranks anzuordnen, in welchem die Gefahr einer Kontaktierung der Einrichtungen durch das austretende Kältemittel und einer damit einhergehenden Explosionsgefahr eliminiert oder zumindest reduziert wird. Dazu werden die Einrichtungen des Klimaschranks, die eine Zündung des Kältemittels hervorrufen können, in Bezug auf die Richtung des Luftstroms vor dem Kältemittelkreislauf angeordnet, so dass aus dem Kältemittelkreislauf austretendes Kältemittel mit dem Luftstrom vom ersten Bereich bzw. von den genannten Einrichtungen weg befördert und damit eine Zündung des Kältemittels durch Funkenbildung bzw. Erhitzung an den Einrichtungen verhindert oder zumindest unwahrscheinlicher wird. Ferner sorgt der Luftstrom dafür, dass sich das austretende Kältemittel mit der im Innern des Klimaschranks befindlichen Luft so stark vermischt, dass die Konzentration des Kältemittels in der Luft hinreichend reduziert wird. Dadurch wird die Gefahr einer Entzündung des Kältemittel-Luft-Gemisches und einer damit einhergehende Explosion eliminiert oder zumindest verringert, falls das Kältemittel-Luft-Gemisch dennoch mit den genannten Einrichtungen in Kontakt kommen sollte.

Ein solcher Klimaschrank kann im Raum flexibel, und muss insbesondere nicht notwendigerweise an einer Wand, aufgestellt werden, da keine zusätzlichen Luftkanäle bzw. Kältemittelleitungen zur Abfuhr der aus der Raumluft entnommenen Wärme mehr montiert werden müssen. Damit ist sogar eine Positionierung mitten im Raum möglich. Der Klimaschrank kann dadurch sozusagen als "steckerfertiges" - also nach Einstecken des Netzsteckers quasi betriebsbereites - Gerät an einen Kunden bzw. Einsatzort wie etwa eine Baustelle geliefert werden, vorzugsweise inklusive einer vollständigen Füllung mit Kältemittel, so dass eine hohe Reinheit des eingesetzten Kältemittels und Qualität der Ausführung gewährleistet werden können, da z.B. keine Kältemittelleitungen auf der Baustelle gelötet werden müssen. Durch die vorzugsweise vorgesehene Übergabe der aus der Raumluft entnommenen Wärmeenergie mittels Kühlflüssigkeit, insbesondere Wasser, an eine Heizvorrichtung ist eine Nutzung der der Raumluft entnommenen Wärme an einer anderen Stelle möglich. So kann z.B. Abwärme aus einem Serverraum etwa zur Brauchwassererwärmung oder Gebäudebeheizung an anderer Stelle verwendet werden.

Ein solcher Klimaschrank eignet sich aufgrund seiner Kompaktheit und einfachen und flexiblen Aufstellbarkeit besonders zur Verwendung bei der Kühlung von Prozessen, etwa Herstellungs- und/oder Arbeitsprozessen, verschiedenster Art. So kann der Klimaschrank beispielsweise im Bereich einer Spritzgussmaschine aufgestellt werden, wobei die aus dem Klimaschrank austretende Luft zur Kühlung des Spritzgussprozesses, insbesondere der Spritzgießform und/oder des jeweils hergestellten Spritzgussteils, eingesetzt wird.

Insgesamt werden bei dem erfindungsgemäßen Klimaschrank und Wärmerückgewinnungssystem bei flexibler Einsetzbarkeit, einfacher Inbetriebnahme und effizienter Energienutzung etwaige Gefahren durch ggf. austretendes Kältemittel reduziert.

In einer bevorzugten Ausführungsform ist bzw. sind die Strömungseinrichtung und/oder die mindestens eine Zündquelle in Bezug auf die Richtung des Luftstroms vor allen im Gehäuse befindlichen kältemittelführenden Komponenten des Kältemittelkreislaufs angeordnet. Dadurch wird erreicht, dass die Gefahr einer Funkenbildung, Erhitzung bzw. Zündung von aus dem Kältemittelkreislauf eventuell austretendem Kältemittel weiter reduziert, insbesondere verhindert, wird.

Vorzugsweise befinden sich alle kältemittelführenden Komponenten des Kältemittelkreislaufs und/oder befindet sich der gesamte Kältemittelkreislauf im Inneren des Gehäuses und sind bzw. ist dort so angeordnet, dass sich die Komponenten bzw. der Kältemittelkreislauf bezogen auf die Richtung des Luftstroms hinter der Strömungseinrichtung und/oder hinter der mindestens einen Zündquelle befinden bzw. befindet.

Der Kältemittelkreislauf weist vorzugsweise folgende kältemittelführende Komponenten auf: mindestens einen Verdampfer, welcher dazu eingerichtet ist, ein im Kältemittelkreislauf befindliches Kältemittel unter Aufnahme von Wärme aus der durch das Gehäuse strömenden Luft zu verdampfen, mindestens einen Verdichter (Kompressor), der dazu eingerichtet ist, gasförmiges Kältemittel zu verdichten, mindestens einen Verflüssiger (Kondensator), welcher dazu eingerichtet ist, das Kältemittel unter Abgabe von Wärme, insbesondere an eine Kühlflüssigkeit wie z.B. Wasser, zu verflüssigen, und/oder mindestens ein Expansionsventil (Drossel), durch welches der Druck des Kältemittels reduziert wird.

Vorzugsweise sind die kältemittelführenden Komponenten im Inneren des Gehäuses so angeordnet, dass sich nicht nur die für eine Wärmeaufnahme bzw. Wärmeabgabe vorgesehene Komponente im Luftstrom befindet, sondern auch die jeweils anderen Komponenten.

Ist z.B. der Klimaschrank zur Luftkühlung vorgesehen, ist der Verdampfer so ausgeführt und/oder angeordnet, dass er von der durch das Gehäuse strömenden Luft umströmt wird und dabei die für die Verdampfung des Kältemittels nötige Wärme aus der Luft aufnehmen kann. Darüber hinaus sind hierbei aber auch alle weiteren Komponenten des Kältemittelkreislaufs, also insbesondere der Verdichter, der Verflüssiger und das Expansionsventil, im Inneren des Gehäuses so angeordnet, dass sie ebenfalls vom Luftstrom umströmt werden, so dass im Falle einer Leckage ggf. austretendes Kältemittel durch den Luftstrom verdünnt und vorzugsweise aus dem Klimaschrank heraus befördert wird.

Durch die vorstehend beschriebenen bevorzugten Ausführungen können, jeweils einzeln oder in Kombination, etwaige Gefahren durch ggf. austretendes Kältemittel weiter reduziert werden.

Vorzugsweise werden alle potenziellen Zündquellen einschließlich der Strömungseinrichtung in Bezug auf die Richtung des Luftstroms vor dem Kältemittelkreislauf, insbesondere vor allen im Gehäuse befindlichen Komponenten des Kältemittelkreislaufs, angeordnet. Durch den Luftstrom wird aus dem Kältemittelkreislauf gegebenenfalls austretendes Kältemittel dabei von allen potenziellen Zündquellen einschließlich der Strömungseinrichtung weg befördert, so dass eine Zündung des Kältemittels durch Funkenbildung bzw. Erhitzung an den Zündquellen verhindert oder zumindest noch unwahrscheinlicher wird.

In einer weiteren bevorzugten Ausführungsform weist die mindestens eine Zündquelle mindestens ein elektrisches Schaltelement und/oder elektrostatisch aufladbares Element und/oder Element mit hoher Oberflächentemperatur auf. Das mindestens eine elektrische Schaltelement kann beispielsweise zum Ein- und Ausschalten des Kühl- bzw. Heizbetriebs und/oder Auswählen einzelner Funktionen des Klimaschranks dienen. Beim Schaltvorgang kann es zu einer Funkenbildung zwischen den elektrischen Kontaktflächen des Schaltelements kommen, die zu einer Zündung des Kältemittel-Luft-Gemisches führen kann, wenn sich dieses in einer ausreichenden Konzentration im Bereich des Schalters befindet. Entsprechendes gilt für elektrostatisch aufladbare Elemente wie etwa Flächen zur Lenkung des Luftstroms oder Ventilatorflügel, die durch Luftreibung und/oder Reibung, z.B. eines Laufrads an einer Düse, elektrostatisch aufgeladen werden können und sich durch Funkenentladung wieder entladen können. Bei Elementen mit hoher Oberflächentemperatur kann es sich z.B. um elektrische Leitungen, Transformatoren, durch Reibung erwärmte Ventilatorlager oder Flüssigkeitsleitungen handeln, die aufgrund von Stromfluss bzw. Flüssigkeitsstroms so stark erwärmt werden, dass eine Entzündung des Kältemittel-Luft-Gemisches möglich wird. Da die vorgenannten Zündquellen aber vorzugsweise in einem Bereich angeordnet sind, der sich - in Richtung des Luftstroms betrachtet - vor dem Kältemittelkreislauf befindet, kann die Gefahr einer Entzündung des Kältemittels eliminiert oder zumindest stark vermindert werden.

In einer weiteren bevorzugten Ausführungsform weist die Strömungseinrichtung einen Ventilator auf. Durch die Verwendung eines Ventilators wird der durch das Gehäuse strömende Luftstrom auf einfache Weise erzeugt und beibehalten.

Ferner lässt sich durch den Ventilator auch eine Anpassung des Luftstroms erreichen.

In einer weiteren bevorzugten Ausführungsform ist die Strömungseinrichtung im Bereich der ersten Öffnung des Gehäuses angeordnet. Dadurch wird auf einfache Weise gewährleistet, dass sich die Strömungseinrichtung, die aufgrund möglicher Funkenbildung z.B. im elektrischen Antrieb und/oder durch elektrostatische Aufladung und/oder im durch Reibung erwärmten Ventilatorlager eine potenzielle Zündquelle darstellt, in Luftstromrichtung betrachtet stets vor den im Inneren des Gehäuses befindlichen Komponenten des Kältemittelkreislaufs befindet, so dass eine Entzündung von austretendem Kältemittel an der Strömungseinrichtung besonders unwahrscheinlich ist.

In einer weiteren bevorzugten Ausführungsform befinden sich die erste Öffnung in einem oberen Bereich des Gehäuses und die zweite Öffnung in einem unteren Bereich des Gehäuses. Durch diese Anordnung der ersten und zweiten Öffnung kann der Luftstrom, welcher im Inneren des Gehäuses bei der ersten und zweiten Öffnung des Gehäuses ein- bzw. austritt, aufgrund der thermodynamischen Eigenschaften einfach erzeugt und energieeffizient aufrechterhalten werden. Ferner erlaubt diese Anordnung eine einfache Separierung zwischen einem sicheren oberen Bereich und einem explosionsgefährdeten unteren Bereich.

Vorzugsweise ist mindestens ein Sensor, insbesondere ein Gassensor, vorgesehen, welcher dazu eingerichtet ist, aus dem Kältemittelkreislauf ausgetretenes Kältemittel und/oder Kältemittel-Luft-Gemisch zu detektieren und ein entsprechendes Sensorsignal zu erzeugen. Der Sensor kann sich innerhalb des Gehäuses oder im Kühlwasser befinden, insbesondere auf Höhe und/oder unterhalb der kältemittelführenden Komponenten, um innerhalb des Gehäuses befindliches Kältemittel bzw. Kältemittel-Luft-Gemisch zu detektieren. Alternativ oder zusätzlich kann sich der mindestens eine Sensor aber auch außerhalb des Gehäuses befinden, um bereits in den zu klimatisierenden Raum ausgetretenes Kältemittel bzw. Kältemittel-Luft-Gemisch zu detektieren. Vorzugsweise befindet sich der Sensor in der Nähe des Bodens des Gehäuses und/oder des zu klimatisierenden Raums.

Vorzugsweise ist eine Steuerungseinrichtung vorgesehen, welche dazu eingerichtet ist, die Strömungseinrichtung, insbesondere den Ventilator, die Kompressionskältemaschine bzw. Kompressionswärmemaschine und/oder mindestens eine im Gehäuse befindliche elektrische Zündquelle in Abhängigkeit von dem Sensorsignal derart zu steuern, dass im Falle einer Detektion von aus dem Kältemittelkreislauf und/oder dem Gehäuse ausgetretenem Kältemittel und/oder Kältemittel-Luft-Gemisch die Strömungseinrichtung mit einer Stromquelle gekoppelt wird bzw. bleibt und, insbesondere weiterhin, einen Luftstrom erzeugt, durch welchen das ausgetretene Kältemittel bzw. Kältemittel-Luft-Gemisch verdünnt wird, wohingegen die Kompressionskältemaschine bzw. Kompressionswärmemaschine und/oder die mindestens eine im Gehäuse befindliche elektrische Zündquelle von der Stromquelle entkoppelt wird bzw. werden. Dadurch wird gewährleistet, dass im Falle eines mit einem Defekt verbundenen Kältemittelaustritts nur die einen Luftstrom erzeugende Strömungseinrichtung an die Stromversorgung gekoppelt bleibt bzw. wird, so dass eine Verdünnung des ausgetretenen Kältemittels bzw. Kältemittel-Luft-Gemisches mit Luft und eine damit einhergehenden Reduktion der Entzündlichkeit erreicht wird. Darüber hinaus wird die Gefahr einer Entzündung des (verdünnten) Gemisches durch stromführende Komponenten des Klimaschranks auf ein Minimum reduziert, indem außer der Strömungseinrichtung alle übrigen stromführenden Komponenten stromlos geschaltet werden.

Vorzugsweise ist die Stromquelle als unabhängige Stromversorgung (USV) ausgebildet, welche insbesondere im Falle eines Stromausfalls eine Stromversorgung der Strömungseinrichtung ermöglicht. Beispielsweise kann als USV ein elektrischer Energiespeicher, etwa in Form eines Akkus oder einer Batterie, vorgesehen sein, durch welchen bei Stromausfall die Strömungseinrichtung mit Strom versorgt wird. Ein solcher Energiespeicher kann im Klimaschrank selbst integriert sein und/oder aber auch als separate Einheit vorgesehen sein.

Dadurch wird eine Verdünnung des, insbesondere auch in den umgebenden bzw. zu klimatisierenden Raum, ausgetretenen Kältemittels bzw. Kältemittel-Luft-Gemischs durch den von der Strömungseinrichtung erzeugten Luftstrom sichergestellt, so dass die Gefahr einer Entzündung des Kältemitte-Luft-Gemisches durch im Gehäuse und/oder aber auch im Raum befindliche Zündquellen, wie z.B. elektrische Geräte, Computer etc., durch eine erneute Bestromung nach einem Stromausfall und/oder nach Beendigung des Stromausfalls zuverlässig minimiert werden kann.

Die vorstehend beschriebene Ausführung stellt sozusagen eine Zwangslüftung des Raums durch den Klimaschrank selbst dar, durch die eine Verdünnung eines (zunächst) zündfähigen Kältemittel-Luft-Gemisches sichergestellt wird.

In einer weiteren bevorzugten Ausführungsform weist das im Kältemittelkreislauf befindliche Kältemittel einen nichthalogenierten Kohlenwasserstoff auf. Nichthalogenierte Kohlenwasserstoffe sind aufgrund ihrer thermodynamischen Eigenschaften und ihrer Umweltfreundlichkeit, etwa gegenüber halogenierten Kohlenwasserstoffen, vorteilhaft. Vorzugsweise weist das im Kältemittelkreislauf befindliche Kältemittel Propan oder Butan, insbesondere Isobutan, auf. Diese sind für einen breiten Einsatzbereich besonders geeignet.

Vorteilhafterwiese kann ein brennbares Kältemittel eingesetzt werden. Ein brennbares Kältemittel ist vorzugsweise ein Kältemittel, das in die Sicherheitsgruppen "A2", "A2L", "A3", "B2" oder "B3" gemäß DIN EN 378 vom 1. März 2017 eingeordnet ist.

Alternativ kann aber auch ein Kältemittel eingesetzt werden, das nicht brennbar ist und/oder keine Flammenausbreitung zeigt und vorzugsweise in die Sicherheitsgruppen "A1" oder "B1" gemäß DIN EN 378 vom 1. März 2017 eingeordnet ist.

Es ist ferner bevorzugt, dass das im Kältemittelkreislauf befindliche Kältemittel R1234yf (2,3,3,3-Tetrafluorpropen) und/oder R1234ze (trans-1,3,3,3-Tetrafluorprop-1-en) aufweist.

Vorzugsweise weist das im Kältemittelkreislauf befindliche Kältemittel ein GWP (Global Warming Potential, Treibhauspotenzial) von weniger als 150 auf.

Vorzugsweise weist die mindestens eine kältemittelführende Komponente mindestens einen im Gehäuse befindlichen Verdampfer auf, welcher dazu eingerichtet ist, ein im Kältemittelkreislauf befindliches Kältemittel unter Aufnahme von Wärme aus der durch das Gehäuse strömenden Luft zu verdampfen. Alternativ oder zusätzlich weist die mindestens eine kältemittelführende Komponente mindestens einen im Gehäuse befindlichen Kondensator auf, welcher dazu eingerichtet ist, das Kältemittel unter Abgabe von Wärme an eine Kühlflüssigkeit, insbesondere an Wasser, zu verflüssigen.

Vorzugsweise weist der Kondensator mindestens einen ersten Anschluss auf, durch welchen dem Kondensator Kühlflüssigkeit, insbesondere Wasser, zugeführt werden kann. Alternativ weist der Kondensator mindestens einen zweiten Anschluss auf, durch welchen die dem Kondensator zugeführte und durch Aufnahme von Wärme bei der Verflüssigung des Kältemittels erwärmte Kühlflüssigkeit vom Kondensator abgeführt werden kann.

Vorzugsweise ist der Kondensator als Plattenwärmetauscher ausgebildet, welcher mehrere, insbesondere profilierte, Platten aufweist, welche durch Zwischenräume voneinander beabstandet sind, wobei die Zwischenräume so mit dem ersten und zweiten Anschluss gekoppelt und/oder verschaltet sind, dass in jeweils aufeinanderfolgenden Zwischenräumen abwechselnd das Kältemittel und die Kühlflüssigkeit, insbesondere Wasser, fließen können.

Bei einem Plattenwärmetauscher, welcher auch als Plattenwärmeüberträger oder Plattenkühler bezeichnet wird, handelt es sich um eine Bauform eines Wärmeüberträgers, der vorzugsweise wellenförmig profilierte Platten aufweist, die so zusammengesetzt sind, dass jeweils in aufeinanderfolgenden Zwischenräumen zwischen den Platten einmal das aufzuwärmende Medium (zugeführte Kühlflüssigkeit, insbesondere Wasser) und danach das wärmeabgebende Medium (Kältemittel, beispielsweise Propan, Butan oder Isobutan) fließt. Das Plattenpaket ist vorzugsweise nach außen und zwischen den Medien abgedichtet und wird beispielsweise mit Spannschrauben zusammengehalten. Im Vergleich etwa zu einem Luftwärmetauscher ist die Leistungsdichte eines solchen Plattenwärmetauschers deutlich erhöht, so dass das Volumen entsprechend klein gehalten werden kann. Dadurch wird im Vergleich zu Systemen mit Luftwärmetauscher deutlich weniger Kältemittel benötigt, was gerade bei der Verwendung brennbarer Kältemittel von Vorteil ist, da durch die deutlich geringere benötigte Kältemittelmenge eine geringere Brandlast erzielt wird.

Weitere Vorteile, Merkmale und Anwendungsmöglichkeiten der vorliegenden Erfindung ergeben sich aus der nachfolgenden Beschreibung in Zusammenhang mit den Figuren. Es zeigen:
- **Fig. 1**: ein Beispiel eines Klimaschranks;
- **Fig. 2**: ein weiteres Beispiel eines Klimaschranks; und
- **Fig. 3**: ein Beispiel eines Wärmerückgewinnungssystems.

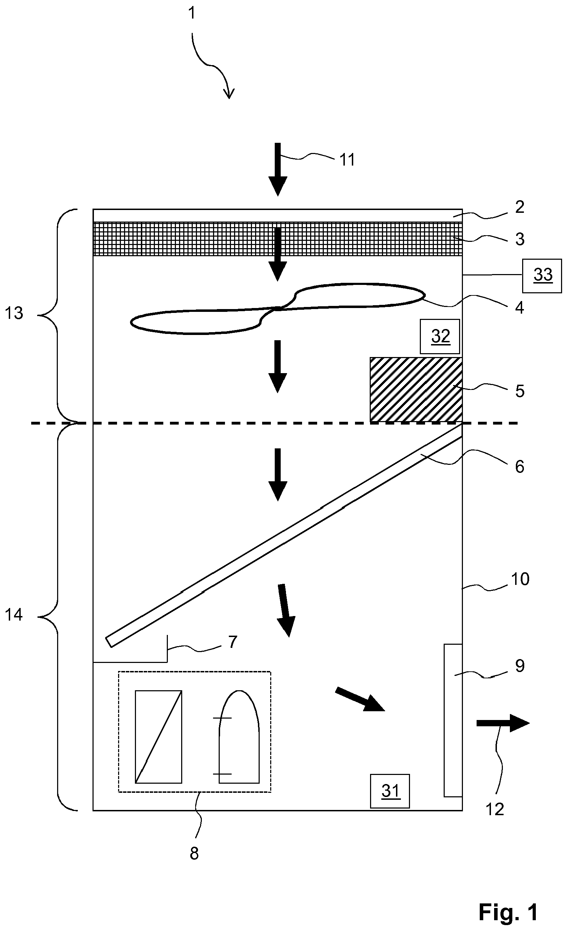

Figur 1 zeigt ein Beispiel eines Klimaschranks 1 mit einem Gehäuse 10, das am oberen Ende eine erste Öffnung 2 aufweist, durch welche Luft 11 aus der Umgebung in das Innere des Klimaschranks 1 gelangt.

Eine im oberen Bereich 13 des Gehäuses 10 angeordnete Strömungseinrichtung 4 saugt die Luft 11 über einen Luftfilter 3 an und drückt diese in das Gehäuse 10, so dass ein Luftstrom (durch Pfeile veranschaulicht) zwischen der ersten Öffnung 2 und einer in einem unteren Bereich 14 des Gehäuses 10 vorgesehenen zweiten Öffnung 9 des Klimaschranks 1 entsteht. Die Strömungseinrichtung 4 ist im dargestellten Beispiel als Ventilator ausgebildet und im Bereich der ersten Öffnung 2 des Gehäuses 10 angeordnet.

Im unteren Bereich 14 des Klimaschrankgehäuses 10 sind Komponenten 6 und 8 eines geschlossenen Kältemittekreislaufs einer Kompressionskältemaschine untergebracht, nämlich ein Verdampferregister 6 und weitere Komponenten, wie z.B. ein Verdichter (Kompressor), Verflüssiger (Kondensator) und/oder ein Expansionsventil (Drossel), welche zusammen durch die Bezugsziffer 8 gekennzeichnet und unter dem Verdampferregister 6 angeordnet sind.

Das Verdampferregister 6 ist vorzugsweise so angeordnet und/oder beschaffen, dass ein möglichst guter Wärmeaustausch mit dem Luftstrom ermöglicht wird. Dabei wird das Verdampferregister 6 vom Luftstrom vorzugsweise vollständig umströmt.

Die übrigen Komponenten 8, insbesondere der Verflüssiger, sind gegenüber dem Luftstrom vorzugsweise thermisch isoliert, so dass eine Erwärmung der nach Passieren des Verdampferregisters 6 abgekühlten Luft durch den Verflüssiger unterbunden wird.

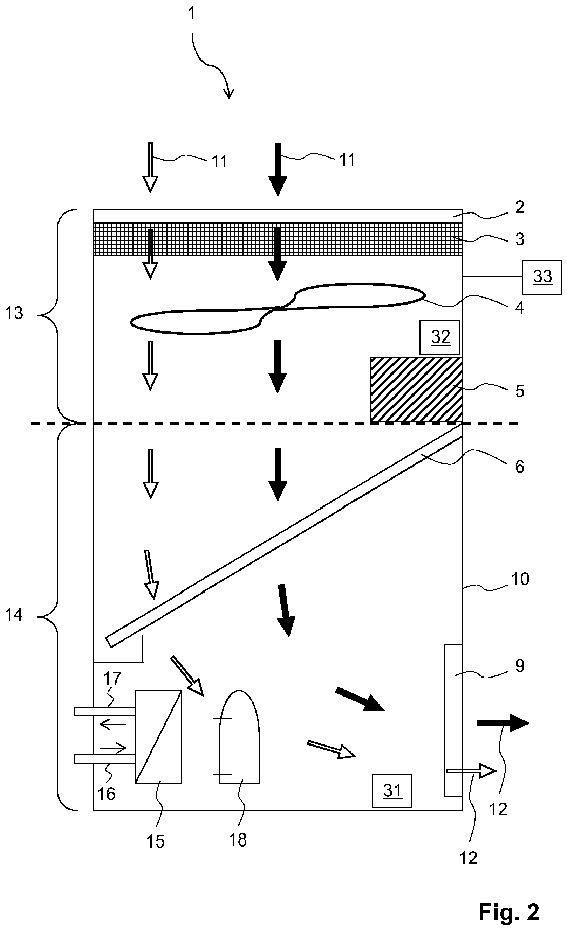

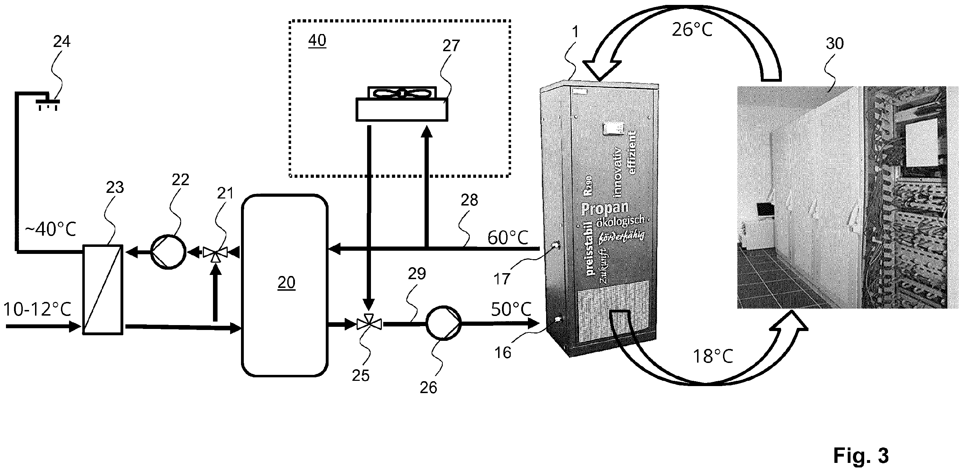

Am Verflüssiger abgegebene Wärmeenergie wird vorzugsweise zur Wärmerückgewinnung in ein Warmwasser- bzw. Heizungsnetz eingespeist. Dies wird weiter unten anhand der in den Figuren 2 und 3 gezeigten Beispiele näher erläutert.

Die kältemittelführenden Komponenten 6 und 8 der Kompressionskältemaschine sind vorzugsweise durch gelötete Verbindungen miteinander verbunden, um die Gefahr einer Leckage gering zu halten.

Das Verdampferregister 6 ist gegenüber der Grundfläche des Klimaschranks 1 bzw. der Horizontalen geneigt angeordnet und vorzugsweise korrosionsbeständig ausgeführt. Unterhalb des Verdampferregisters 6 befindet sich eine Kondensatwanne 7, an welcher ein Schlauch (nicht dargestellt) angeschlossen ist, durch welchen Kondenswasser, das beim Abkühlen der Luft 11 am Verdampferregister 6 abschieden wird, abgeleitet wird.

Die Strömungseinrichtung 4 stellt eine potenzielle Zündquelle dar, da z.B. an den Flügeln und/oder im Elektromotor des Ventilators durch elektrostatische Aufladung bzw. elektrische Spannungen Funken auftreten können.

Im oberen Bereich 13 ist ferner wenigstens eine Schalteinrichtung 5 angeordnet, welche ebenfalls potenzielle Zündquellen wie etwa elektrische Schaltelemente, elektrostatisch aufladbare Elemente und/oder Elemente mit hoher Oberflächentemperatur aufweisen kann.

Durch die Anordnung von, vorzugsweise allen, potenziellen Zündquellen - in Luftstromrichtung betrachtet - vor dem unteren Bereich 14 des Gehäuses 10, in dem sich die kältemittelführenden Komponenten 6 und 8 der Kompressionskältemaschine und somit potenzielle Leckagestellen für den Austritt von Kältemittel befinden, wird die Gefahr einer Entzündung bzw. Explosion von gegebenenfalls austretendem Kältemittel reduziert oder sogar ganz verhindert, da austretendes Kältemittel von den im oberen Bereich 13 befindlichen potenziellen Zündquellen weg befördert, mit Luft vermischt und entsprechend verdünnt wird.

Die zweite Öffnung 9 ist im unteren Bereich 14 des Gehäuses 10 angeordnet und befindet sich im gezeigten Beispiel etwa auf der Höhe der übrigen Komponenten 8 der Kompressionskältemaschine. Durch die zweite Öffnung 9 aus dem Gehäuse 10 austretende Luft 12 strömt im Bodenbereich anschließend wieder zu Wärmequellen in der Umgebung des Klimaschranks 1.

Durch die vorstehend beschriebene Anordnung der Strömungseinrichtung 4 bzw. potenzieller Zündquellen, wie etwa der Schalteinrichtung 5, in einem Bereich 13, der in Luftstromrichtung betrachtet vor den kältemittelführenden Komponenten 6 und 8 des Kältemittelkreislaufs liegt, wird das Gehäuse 10 des Klimaschranks 1 in unterschiedliche Gefahrenbereiche unterteilt, wobei der obere Bereich 13 eine sichere Zone und der untere Bereich 14 einen Gefahrenbereich darstellen.

Im Regelbetrieb des Klimaschranks 1 ist von keiner Gefahr einer Entzündung des Kältemittels auszugehen, da sich das Kältemittel wie bei herkömmlichen Kälteanlagen in einem geschlossenen Kreislauf befindet und keine zündfähige Atmosphäre bilden kann. Im Stör- oder Schadensfall kann unter ungünstigen Umständen ohne die erfindungsgemäßen Maßnahmen eine zeitweise zündfähige Atmosphäre entstehen.

Im dargestellten Beispiel wird die aus der Umgebung angesaugte Luft 11 am oberen Ende des Gehäuses 10 angesaugt und durchströmt dieses zum unteren Ende hin, wo sie gekühlt wieder aus dem Gehäuse 10 austritt. Der Ventilator 4 und die Schalteinrichtung 5 sind dabei oberhalb der kältemittelführenden Komponenten 6 und 8 der Kompressionskältemaschine angeordnet.

Es ist aber auch möglich, dass Luft 11 aus der Umgebung am unteren Ende des Gehäuses 10 angesaugt wird und das Gehäuse 10 zum oberen Ende hin durchströmt, wo sie gekühlt wieder aus dem Gehäuse 10 austritt. In diesem Fall sind der Ventilator 4 im Bereich der unteren Öffnung 9 und die Schalteinrichtung 5 im unteren Bereich 14 des Gehäuses 10 und die kältemittelführenden Komponenten 6 und 8 der Kompressionskältemaschine im oberen Bereich 13 des Gehäuses 10 angeordnet. Damit sind auch bei dieser Ausführung potenzielle Zündquellen - in Luftstromrichtung betrachtet - vor den kältemittelführenden Komponenten 6 und 8 der Kompressionskältemaschine angeordnet, so dass die Gefahr einer Entzündung bzw. Explosion von gegebenenfalls austretendem Kältemittel reduziert oder sogar ganz verhindert wird, da austretendes Kältemittel von den im unteren Bereich 14 des Gehäuses 10 befindlichen potenziellen Zündquellen, wie dem Ventilator 4 und/oder Komponenten der Schalteinrichtung 5, weg befördert, mit Luft vermischt und entsprechend verdünnt wird.

Vorzugsweise wird durch eine vollhermetische Anlagenausführung, bei welcher vor Befüllen der Anlage mit Kältemittel ein Tiefvakuum von weniger als 3 mbar im Kältemittelkreislauf vorherrscht, ein Niederdruck-Schaltelement zur sicheren Abschaltung und Reduzierung der Gefahr, dass Fremdgase in den Kreislauf gelangen, und eine Auswahl von Bauteilen, welche geringe Zündpotenziale aufweisen, die Entzündbarkeit im Kältemittelkreislauf weiter reduziert, insbesondere verhindert. Ferner sind vorzugsweise alle Verbindungen des Kältemittelkreislaufs gelötet, sodass ein zusätzlicher Schutz gegen einen Kältemittelaustritt aus dem Kältemittelkreislauf erreicht wird.

Mit Hilfe des für den Wärmetransport nötigen Luftstroms wird eine vorzugsweise dauerhafte Luftströmung und Verdünnung des austretenden brennbaren Kältemittels bei einem außerplanmäßigen Kältemittelaustritt sichergestellt. Eine Entzündung der mit brennbaren Gasen versetzten Luft ist bei einer Verdünnung unter einer vorbestimmten unteren Explosionsgrenze unwahrscheinlich.

Neben den beschriebenen Sicherheitsmaßnahmen wird eine kältemittelmengenreduzierte Bauweise bevorzugt. Diese senkt das Potenzial einer Entzündung bzw. Explosion eines aus dem Kältemittelkreislauf ausgetreten Kältemittels weiter und wird durch eine Kältemittelreduzierung in den Flüssigkeitsleitungen realisiert.

Der Einsatz eines aus einem Schauglas und einem Filter zusammengesetzten Kombinationsbauteils reduziert das Flüssigkeitsvolumen im Vergleich zu herkömmlichen Filtertrocknern zusätzlich und hält Schmutzpartikel im Anlagenkreislauf zurück. Durch das Schauglas kann auf den Zustand des Kältemittels beispielsweise anhand von Dampfblasen und/oder einer Verfärbung geschlossen werden. Ferner können auch die Rohrleitungen des Kältemittelkreislaufs durch möglichst kurze Verbindungswege zu den einzelnen kältetechnischen Bauteilen zu einer kältemittelreduzierten Bauweise beitragen.

Bevorzugte Ausführungsformen des Klimaschranks stehen mit den ATEX-(ATmospheres EXplosibles) Richtlinien der Europäischen Union und vorzugsweise auch mit anderen Normen und Richtlinien zum Explosionsschutz im Einklang.

Das Kältemittel weist bevorzugt einen nichthalogenierten Kohlenwasserstoff auf. Vorzugsweise weist das Kältemittel wenigstens eine natürliche Kältemittelkomponente und/oder eine Komponente mit einem GWP (Global Warming Potential, Treibhauspotenzial) von weniger als 150, wie z.B. Propan R290 oder Isobutan R600a und/oder weiter vorzugsweise andere Kältemittelkomponenten wie R1234yf, R1234ze, Kohlenstoffdioxid oder Wasser auf.

Es ist ferner bevorzugt, dass der Klimaschrank 1 lediglich eine Füllmenge an Kältemittel von höchstens 150 g je Kältemittelkreislauf benötigt, wodurch Anforderungen an den Brandschutz besonders gering gehalten werden können.

Vorzugsweise ist mindestens ein Sensor 31, insbesondere ein Gassensor, vorgesehen, welcher dazu eingerichtet ist, aus dem Kältemittelkreislauf 6, 8 ausgetretenes Kältemittel und/oder Kältemittel-Luft-Gemisch zu detektieren und ein entsprechendes Sensorsignal zu erzeugen. Der Sensor 31 kann sich - wie im vorliegenden Beispiel - innerhalb des Gehäuses 10 befinden, insbesondere auf Höhe und/oder unterhalb der kältemittelführenden Komponenten 6, 8, und/oder im Bodenbereich des Gehäuses 10, um innerhalb des Gehäuses 10 befindliches Kältemittel bzw. Kältemittel-Luft-Gemisch zu detektieren. Alternativ oder zusätzlich kann sich der mindestens eine Sensor 31 aber auch außerhalb des Gehäuses 10 befinden (nicht dargestellt), um bereits in den zu klimatisierenden Raum ausgetretenes Kältemittel bzw. Kältemittel-Luft-Gemisch zu detektieren.

Vorzugsweise ist eine Steuerungseinrichtung 32 vorgesehen, welche dazu eingerichtet ist, die Strömungseinrichtung 4, insbesondere den Ventilator, die Kompressionskältemaschine bzw. Kompressionswärmemaschine und/oder mindestens eine im Gehäuse 10 befindliche elektrische Zündquelle 5 in Abhängigkeit von dem Sensorsignal derart zu steuern, dass im Falle einer Detektion von aus dem Kältemittelkreislauf 6, 8 und/oder dem Gehäuse 10 ausgetretenem Kältemittel und/oder Kältemittel-Luft-Gemisch die Strömungseinrichtung 4 mit einer Stromquelle 3 gekoppelt wird bzw. bleibt und, insbesondere weiterhin, einen Luftstrom 11 erzeugt, durch welchen das ausgetretene Kältemittel bzw. Kältemittel-Luft-Gemisch verdünnt wird, wohingegen die Kompressionskältemaschine bzw. Kompressionswärmemaschine und/oder die mindestens eine im Gehäuse 10 befindliche elektrische Zündquelle 5 von der Stromquelle 33 entkoppelt wird bzw. werden. Dadurch wird gewährleistet, dass im Falle eines mit einem Defekt verbundenen Kältemittelaustritts nur die den Luftstrom 1 erzeugende Strömungseinrichtung 4 an die Stromversorgung 33 gekoppelt bleibt bzw. wird, so dass eine Verdünnung des ausgetretenen Kältemittels bzw. Kältemittel-Luft-Gemisches mit Luft und eine damit einhergehenden Reduktion der Entzündlichkeit erreicht wird. Darüber hinaus wird die Gefahr einer Entzündung des (verdünnten) Gemisches durch stromführende Komponenten 5 des Klimaschranks 1 auf ein Minimum reduziert, indem außer der Strömungseinrichtung 4 vorzugsweise alle übrigen stromführenden Komponenten 5 stromlos geschaltet werden.

Vorzugsweise ist die Stromquelle 33 als unabhängige Stromversorgung (USV) ausgebildet, welche insbesondere im Falle eines Stromausfalls eine Stromversorgung der Strömungseinrichtung 4 ermöglicht. Beispielsweise kann als USV ein elektrischer Energiespeicher, etwa in Form eines Akkus oder einer Batterie, vorgesehen sein, durch welchen bei Stromausfall die Strömungseinrichtung 4 mit Strom versorgt wird. Ein solcher Energiespeicher kann im Klimaschrank 1 selbst integriert sein und/oder aber auch - wie im gezeigten Beispiel angedeutet - als separate Einheit vorgesehen sein. Dadurch wird eine Verdünnung des, insbesondere auch in den umgebenden bzw. zu klimatisierenden Raum, ausgetretenen Kältemittels bzw. Kältemittel-Luft-Gemischs durch den von der Strömungseinrichtung erzeugten Luftstrom 1 sichergestellt, so dass die Gefahr einer Entzündung des Kältemitte-Luft-Gemisches durch im Gehäuse 10 und/oder aber auch im Raum befindliche Zündquellen, wie z.B. elektrische Geräte, Computer etc., bei einer erneuten Bestromung nach einem Stromausfall und/oder nach Beendigung des Stromausfalls zuverlässig minimiert werden kann.

Figur 2 zeigt ein weiteres Beispiel eines Klimaschranks 1, für welchen grundsätzlich die vorstehenden Ausführungen im Zusammenhang mit dem in Figur 1 gezeigten Beispiel entsprechend gelten.

Im vorliegenden Beispiel sind neben dem Verdampferregister 6 auch die weiteren Komponenten, insbesondere ein Verflüssiger (Kondensator) 15 und/oder ein Verdichter (Kompressor) 18, des Kältemittelkreislaufs im Inneren des Gehäuses 10 so positioniert, dass diese vom Luftstrom, insbesondere von dem durch nicht ausgefüllte Pfeile veranschaulichten Teil des Luftstroms, umströmt werden können, so dass ggf. austretendes Kältemittel durch den Luftstrom verdünnt und vorzugsweise durch die zweite Öffnung 9 aus dem Gehäuse 10 befördert wird.

Während das Verdampferregister 6 dazu eingerichtet ist, im Kältemittelkreislauf befindliches flüssiges Kältemittel unter Aufnahme von Wärme aus der durch das Gehäuse 10 strömenden Luft zu verdampfen, wird das verdampfte Kältemittel nach einer anschließenden Kompression durch den Verdichter 18 im Verflüssiger 15 unter Abgabe von Wärme an eine Kühlflüssigkeit, insbesondere an Wasser, wieder verflüssigt. Dazu weist der Verflüssiger 15 einen ersten Anschluss 16, durch welchen die Kühlflüssigkeit zugeführt, und einen zweiten Anschluss 17, durch welchen die erwärmte Kühlflüssigkeit wieder abgeführt werden kann, auf.

Vorzugsweise ist der Verflüssiger 15 als Plattenwärmetauscher ausgebildet, welcher mehrere, vorzugsweise profilierte und/oder wellenförmige, Platten aufweist, die durch Zwischenräume voneinander beabstandet sind. Die Zwischenräume sind dabei so mit dem ersten Anschluss 16 und zweiten Anschluss 17 verbunden und/oder verschaltet, dass in jeweils aufeinanderfolgenden Zwischenräumen abwechselnd das Kältemittel und die Kühlflüssigkeit, insbesondere Wasser, fließen können. Im Vergleich etwa zu einem Luftwärmetauscher ist die Leistungsdichte eines solchen Plattenwärmetauschers deutlich erhöht, so dass im Vergleich zu Klimaschränken mit einem Luftwärmetauscher deutlich weniger Kältemittel benötigt wird, was gerade bei einer aus Gründen des Klimaschutzes bevorzugten Verwendung brennbarer Kältemittel wie Propan, Butan oder Isobutan von Vorteil ist, da durch die deutlich geringere benötigte Kältemittelmenge die Brandgefahr bzw. Brandlast reduziert wird.

Zusätzlich zum effizienten Wärmetausch und zur Reduktion der Brandgefahr bietet ein solcher Klimaschrank 1 den Vorteil, dass er für den Einsatz in einem Wärmerückgewinnungssystem besonders geeignet ist.

Figur 3 zeigt ein Beispiel eines Wärmerückgewinnungssystems unter Verwendung eines Klimaschranks 1. Im vorliegenden Beispiel wird der Klimaschrank 1 zur Kühlung eines Serverraums 30 eingesetzt, wobei angesaugte Raumluft mit einer Temperatur von 26°C auf 18°C abgekühlt und wieder in den Serverraum 30 zurückgeleitet wird.

Die bei der Verflüssigung des Kältemittels im Verflüssiger 15 (siehe Figur 2) vom Kältemittel abgegebene Wärme wird an eine über einen ersten Anschluss 16 zugeführte Kühlflüssigkeit, bei der es sich vorzugsweise um Wasser handeln kann, abgegeben. Die dabei im Verflüssiger z.B. von 50°C auf 60°C erwärmte Kühlflüssigkeit verlässt diesen durch einen zweiten Anschluss 17 wieder.

Im gezeigten Beispiel wird die auf 60°C erwärmte Kühlflüssigkeit über eine erste Verbindungsleitung 28 einem thermisch isolierten Pufferspeicher 20 zugeführt, in welchem sie für eine spätere Verwendung vorgehalten wird und/oder bei Bedarf entnommen werden kann.

Im vorliegenden Beispiel wird die Kühlflüssigkeit einer sog. Frischwasserstation 23 zugeführt und dort zur Erwärmung von Brauchwasser, welches z.B. eine Ausgangstemperatur von 10 bis 12°C hat, auf eine Temperatur von z.B. etwa 40°C verwendet. Dazu ist die Frischwasserstation 23 als Wärmetauscher ausgebildet, in welchem Wärme aus der erwärmten Kühlflüssigkeit an das Brauchwasser abgegeben wird, welches dann z.B. an einer Dusche 24 oder einem Wasserhahn entnommen werden kann.

Vorzugsweise durchläuft die erwärmte Kühlflüssigkeit bei ihrem Weg vom Pufferspeicher 20 zur Frischwasserstation 23 ein optionales Dreiwegeventil 21 und eine optionale Pumpe 22, welche die erwärmte Kühlflüssigkeit aus dem Pufferspeicher 20 befördert und/oder einen Rückfluss der aus dem Pufferspeicher 20 herausgeführten erwärmten Kühlflüssigkeit zurück in den Pufferspeicher 20 verhindert. Das optionale Dreiwegeventil 21 ermöglicht eine Mischung zumindest eines Teils der nach der Abkühlung in der Frischwasserstation 23 wieder in den Pufferspeicher 20 zurückgeführten bzw. zurückzuführenden Kühlflüssigkeit mit der aus dem Pufferspeicher 20 herausgeführten erwärmten Kühlflüssigkeit.

Die abgekühlte Kühlflüssigkeit wird über eine zweite Verbindungsleitung 29 vom Pufferspeicher 20 wieder zurück zum Verflüssiger im Klimaschrank 1 geführt. In der zweiten Verbindungsleitung 29 ist im gezeigten Beispiel ein optionales Dreiwegeventil 25 und eine optionale Pumpe 26 vorgesehen, welche die abgekühlte Kühlflüssigkeit aus dem Pufferspeicher 20 befördert und/oder einen Rückfluss der aus dem Pufferspeicher 20 herausgeführten abgekühlten Kühlflüssigkeit zurück in den Pufferspeicher 20 verhindert

Ferner kann optional im Außenbereich 40 eines Gebäudes, insbesondere des Gebäudes, in welchem sich der Serverraum 30 befindet, ein Lufterhitzter 27 vorgesehen sein, der an den Verbindungsleitungen 28, 29 zwischen dem Klimaschrank 1 und dem Pufferspeicher 20 angeschlossen und/oder steuerbar ist, so dass zumindest ein Teil der im Klimaschrank 1 erwärmten Kühlflüssigkeit zum Lufterhitzer 27 gelangen, dort an der Umgebungsluft abgekühlt und über das Dreiwegeventil 25 in die zweite Verbindungsleitung 29 zur Zufuhr zum Klimaschrank 1 eingespeist werden kann. Ein zumindest teilweises oder vorübergehendes Abführen von Wärme über den Lufterhitzer 27 kann im Falle von Wärmeüberschüssen von Vorteil sein, z.B. wenn bei der Kühlung des Serverraumes 30 mehr Wärme gewonnen als zur Erwärmung von Brauchwasser benötigt wird.

Auch wenn im vorliegenden Beispiel die mittels Kühlflüssigkeit am Verflüssiger 15 des Klimaschranks 1 abgeführte Abwärme zur Erwärmung von Brauchwasser verwendet wird, ist es alternativ oder zusätzlich möglich, mit der in der abgeführten Kühlflüssigkeit gespeicherten Wärme eine andere Flüssigkeit, insbesondere Wasser, zur Verwendung bei einer Gebäudeheizung zu verwenden. Anstelle der bzw. zusätzlich zur Zufuhr von Frischwasser und Möglichkeit zur Entnahme von Brauchwasser, also z.B. an einer Dusche 24, ist in diesem Fall am Wärmetauscher 23 ein vorzugsweise geschlossener Heizwasserkreislauf (nicht dargestellt) angeschlossen.

### Bezugszeichenliste

- 1: Klimaschrank
- 2: erste Öffnung
- 3: Luftfilter
- 4: Strömungseinrichtung
- 5: Schalteinrichtung
- 6: Verdampferregister
- 7: Kondensatwanne
- 8: weitere Komponenten der Kompressionskältemaschine
- 9: zweite Öffnung
- 10: Gehäuse
- 11: eintretende Luft
- 12: austretende Luft
- 13: oberer Bereich
- 14: unterer Bereich
- 15: Kondensator, Verflüssiger
- 16: erster Anschluss
- 17: zweiter Anschluss
- 18: Verdichter, Kompressor
- 20: Pufferspeicher
- 21: Dreiwegeventil
- 22: Pumpe
- 23: Frischwasserstation bzw. Wärmetauscher (Heizeinrichtung)
- 24: Dusche
- 25: Dreiwegeventil
- 26: Pumpe
- 27: Lufterhitzer
- 28: erste Verbindungsleitung zur Abfuhr von Kühlflüssigkeit
- 29: zweite Verbindungsleitung zur Zufuhr von Kühlflüssigkeit
- 30: Serverraum
- 31: Sensor, Gassensor
- 32: Steuerungseinrichtung
- 33: Stromquelle
- 40: Außenbereich

## Patentansprüche

1. Klimaschrank (1) zur Klimatisierung, insbesondere zum Heizen und/oder Kühlen, von Räumen, Raumbereichen oder Prozessen mit:
- einem Gehäuse (10) mit einer ersten Öffnung (2) und einer zweiten Öffnung (9),
- mindestens einer Strömungseinrichtung (4), die dazu eingerichtet ist, im Innern des Gehäuses (10) einen Luftstrom zwischen der ersten und zweiten Öffnung (2, 9) des Gehäuses (10) zu erzeugen, wobei Luft aus der Umgebung des Gehäuses (10) durch die erste Öffnung (2) in das Gehäuse (10) hinein und durch die zweite Öffnung (9) wieder aus dem Gehäuse (10) heraus strömt, und
- mindestens einer Kompressionskältemaschine oder Kompressionswärmemaschine mit einem geschlossenen Kältemittelkreislauf, der mindestens eine im Gehäuse (10) befindliche kältemittelführende Komponente (6, 8, 15, 18), insbesondere einen Verdampfer (6) bzw. Kondensator (15), aufweist, durch welche die Temperatur der durch das Gehäuse strömenden Luft beeinflussbar ist,
**dadurch gekennzeichnet, dass**
die Strömungseinrichtung (4) und/oder mindestens eine im Gehäuse (10) befindliche Zündquelle (5), durch welche eine Zündung eines gegebenenfalls im Gehäuse (10) befindlichen Kältemittel-Luft-Gemisches ausgelöst werden kann, in Bezug auf die Richtung des Luftstroms vor der mindestens einen im Gehäuse (10) befindlichen Komponente (6, 8, 15, 18) des Kältemittelkreislaufs angeordnet ist bzw. sind.

2. Klimaschrank (1) nach Anspruch 1, wobei die Strömungseinrichtung (4) und/oder die mindestens eine Zündquelle (5) in Bezug auf die Richtung des Luftstroms vor allen im Gehäuse (10) befindlichen kältemittelführenden Komponenten (6, 8, 15, 18) des Kältemittelkreislaufs angeordnet ist bzw. sind.

3. Klimaschrank (1) nach Anspruch 1 oder 2, wobei die mindestens eine Zündquelle (5) mindestens ein elektrisches Schaltelement und/oder elektrostatisch aufladbares Element und/oder Element mit hoher Oberflächentemperatur aufweist.

4. Klimaschrank (1) nach einem der vorangehenden Ansprüche, wobei die Strömungseinrichtung (4) einen Ventilator aufweist.

5. Klimaschrank (1) nach einem der vorangehenden Ansprüche, wobei die Strömungseinrichtung (4) im Bereich der ersten Öffnung (2) des Gehäuses (10) angeordnet ist.

6. Klimaschrank (1) nach einem der vorangehenden Ansprüche, wobei sich die erste Öffnung (2) in einem oberen Bereich (13) des Gehäuses (10) und die zweite Öffnung (19) in einem unteren Bereich (14) des Gehäuses (10) befinden.

7. Klimaschrank (1) nach einem der vorangehenden Ansprüche mit
- einem Sensor (31), insbesondere einem Gassensor, welcher dazu eingerichtet ist, aus dem Kältemittelkreislauf ausgetretenes Kältemittel und/oder Kältemittel-Luft-Gemisch zu detektieren und ein entsprechendes Sensorsignal zu erzeugen, und
- einer Steuerungseinrichtung (32), welche dazu eingerichtet ist, die Strömungseinrichtung (4), die Kompressionskältemaschine bzw. Kompressionswärmemaschine und/oder mindestens eine im Gehäuse (10) befindliche elektrische Zündquelle (5) in Abhängigkeit von dem Sensorsignal derart zu steuern, dass im Falle einer Detektion von ausgetretenem Kältemittel und/oder Kältemittel-Luft-Gemisch die Strömungseinrichtung (4) mit einer Stromquelle (33) gekoppelt wird bzw. bleibt und den bzw. einen Luftstrom erzeugt, durch welchen das ausgetretene Kältemittel bzw. Kältemittel-Luft-Gemisch verdünnt wird, wohingegen die Kompressionskältemaschine bzw. Kompressionswärmemaschine und/oder die mindestens eine im Gehäuse (10) befindliche elektrische Zündquelle (5) von der Stromquelle (33) entkoppelt wird bzw. werden.

8. Klimaschrank nach Anspruch 7, wobei die Stromquelle (33) als unabhängige Stromversorgung ausgebildet ist, welche insbesondere im Falle eines Stromausfalls eine Stromversorgung der Strömungseinrichtung (4) ermöglicht.

9. Klimaschrank (1) nach einem der vorangehenden Ansprüche, wobei das im Kältemittelkreislauf befindliche Kältemittel brennbar ist.

10. Klimaschrank (1) nach einem der vorangehenden Ansprüche, wobei das im Kältemittelkreislauf befindliche Kältemittel einen nichthalogenierten Kohlenwasserstoff, insbesondere Propan oder Butan, insbesondere Isobutan, aufweist.

11. Klimaschrank (1) nach einem der vorangehenden Ansprüche, wobei
- das im Kältemittelkreislauf befindliche Kältemittel R1234yf und/oder R1234ze aufweist und/oder
- das im Kältemittelkreislauf befindliche Kältemittel ein GWP (Global Warming Potential) von weniger als 150 aufweist.

12. Klimaschrank (1) nach einem der vorangehenden Ansprüche, wobei die mindestens eine kältemittelführende Komponente (6, 8, 15, 18) aufweist:
- mindestens einen im Gehäuse (10) befindlichen Verdampfer (6), welcher dazu eingerichtet ist, ein im Kältemittelkreislauf befindliches Kältemittel unter Aufnahme von Wärme aus der durch das Gehäuse (10) strömenden Luft zu verdampfen, und
- mindestens einen im Gehäuse (10) befindlichen Kondensator (15), welcher dazu eingerichtet ist, das Kältemittel unter Abgabe von Wärme an eine Kühlflüssigkeit, insbesondere Wasser, zu verflüssigen.

13. Klimaschrank (1) nach Anspruch 12, wobei der Kondensator (15) aufweist:
- mindestens einen ersten Anschluss (16), durch welchen dem Kondensator (15) Kühlflüssigkeit, insbesondere Wasser, zugeführt werden kann, und
- mindestens einen zweiten Anschluss (17), durch welchen die dem Kondensator (15) zugeführte und durch Aufnahme von Wärme bei der Verflüssigung des Kältemittels erwärmte Kühlflüssigkeit vom Kondensator abgeführt werden kann.

14. Klimaschrank (1) nach Anspruch 13, wobei der Kondensator (15) als Plattenwärmetauscher ausgebildet ist, welcher mehrere, insbesondere profilierte, Platten aufweist, welche durch Zwischenräume voneinander beabstandet sind, wobei die Zwischenräume so mit dem ersten und zweiten Anschluss gekoppelt und/oder verschaltet sind, dass in jeweils aufeinanderfolgenden Zwischenräumen abwechselnd das Kältemittel und die Kühlflüssigkeit, insbesondere Wasser, fließen können.

15. Wärmerückgewinnungssystem mit einem Klimaschrank (1) nach einem der Ansprüche 12 bis 14 und einer Heizungsvorrichtung (23), welche dazu eingerichtet ist, unter Verwendung der vom Kondensator (15) abgeführten erwärmten Kühlflüssigkeit Brauchwasser und/oder eine Flüssigkeit, insbesondere Wasser, zur Verwendung bei einer Gebäudeheizung zu erwärmen.
